# DEMANDE DE BREVET EUROPEEN

(11) **EP 2 144 276 A2**
(43) Date de publication de la demande: **13.01.2010**
(21) Numéro de dépôt: 09164433.6
(22) Date de dépôt: 02.07.2009
(51) Int. Cl.: H01L 21/00, H01L 21/673

(54) **Dispositif de purge et procédé**

(30) Priorité: 11.07.2008 FR 0854769
(71) Demandeur: Alcatel Lucent, 75008 Paris (FR)
(72) Inventeur: Favre, Arnaud, 74009, ANNECY (FR); Rude, Cindy, 74940, Annecy-le-Vieux (FR); Bellet, Bertrand, 73000, CHAMBERY (FR)
(74) Mandataire: Sciaux, Edmond

(57) **Abrégé**

La présente invention a pour objet un dispositif de purge une boîte de transport ayant une ouverture d'entrée/sortie obturable par une porte de boîte et contenant des plaquettes de substrat superposées selon des plans parallèles. Le dispositif de purge comprend un volume limité par une paroi étanche divisé en au moins une partie supérieure munie d'un orifice d'entrée de gaz de purge et en une partie inférieure munie d'un de sortie de gaz de purge, les deux parties étant séparées par une cloison étanche, et une pluralité de guides définissant des ouvertures disposées dans des plans parallèles à ceux des plaquettes et communiquant avec le volume du dispositif de purge pour diriger le gaz de purge vers le boîte de transport.

## Description

La présente invention se rapporte à un dispositif de purge d'une boîte de transport utilisée pour le déplacement des substrats semi-conducteurs entre les différentes étapes de ta fabrication de composantes semiconducteurs et microélectroniques, par exemple pour la réalisation de composants de microsystèmes électromécaniques (MEMS) ou de microsystèmes électrooptomécaniques (MOEMS).

Au cours de la fabrication, les substrats, tels que des masque ou des tranches de silicium de 200 mm ou de 300 mm de diamètre par exemple, sont transportées dans des boîtes de transport qui les protègent des pollutions présentes dans l'atmosphère des salles blanches. Les boîtes de transport présentent l'avantage de pouvoir maintenir autour des substrats une atmosphère contrôlée, dans laquelle on évite autant que possible la présence de produits contaminant. Pour le transport de substrats en plaquettes de 300 mm de diamètre, on utilise notamment un type de boite de transport, désigné par l'acronyme FOUP (pour « Front Opening Unified Pod » en anglais), comportant une paroi périphérique étanche à ouverture d'entrée-sortie latérale obturable par une porte munie de moyens d'étanchéité. Dans une boîte de transport, les plaquettes sont empilés les unes au-dessus des autres dans une sorte de râtelier que l'on désigne également par les appellations cassette ou panier. Le panier contenant jusqu'à 25 plaquettes (« wafers » en anglais) est généralement, posé ou tenu sur la paroi constituant la base de la boîte de transport.

La boîte de transport peut être accouplée avec une interface d'entrée-sortie de l'équipement de fabrication de composantes semiconducteurs. L'interface est un système permettant le positionnement de la boîte de transport et l'ouverture de sa porte. L'interface comprend habituellement des moyens robotisés d'actionnement de porte pour ouvrir et fermer la porte de la boîte de transport. Cet interface (appelée parfois aussi minienvironnement), est habituellement désignée par le terme module frontal d'équipement et par l'acronyme EFEM (pour « Equipment Front End Module » en anglais).

Le contrôle de la contamination lors de la fabrication de puces électroniques est un challenge important pour l'industrie du semiconducteur. La contamination peut être causée par des particules ou des gaz, qui vont provoquer de la corrosion ou créer des cristaux sur les plaquettes par exemple. Les conséquences de la contamination peuvent être dramatique pour les fabricants de puces car les performances de la puce seront largement diminuées par ces défauts.

Il existe des solutions pour limiter la contamination en installant des systèmes de purge dans les boites de transport de substrats, utilisant avantageusement le vide ou un gaz neutre. Toutefois ces systèmes de purge ne peuvent être utilisés que lorsque la boîte de transport est désolidarisée de l'équipement (US-2007-062,561 ; JP-2007-317 909), c'est à dire lorsqu'elle est fermée. Ce qui pose deux problèmes.

Le premier problème concerne la durée de l'opération de purge, c'est-à-dire le temps de remplacement de l'atmosphère contaminée à l'intérieur de la boîte de transport par un gaz neutre propre, par exemple de l'azote. Ainsi, purger une boîte de transport fermée nécessite d'injecter le gaz propre à travers des ports de purge qui présentent l'inconvénient de ne pas être standard et qui ont une efficacité très limitée. Ainsi, il faut plus de 10 minutes pour purger incomplètement une boîte (R. Bernard and A. Favre : "Using numerical simulation to optimize 300 mm FOUP purging", Solid State Techn., October 2003, p.71). Par ailleurs le procédé sous vide nécessite une mise sous vide de la boîte de transport et un retour à la pression atmosphérique très progressif pour ne pas risquer d'endommager la boîte.

Le deuxième problème est qu'une boîte de transport contenant les substrats peut rester plusieurs heures en communication avec l'équipement. Même s'il est possible d'effectuer une opération de purge après avoir traité la totalité du lot de substrats contenu dans la boîte de transport, des défauts irréversibles sont déjà apparus.

Par conséquent la présente invention a pour but de proposer un dispositif pour purger de manière efficace une boîte de transport FOUP, contenant des plaquettes de substrat, alors qu'elle est toujours connectée à un équipement.

L'invention a encore pour but de proposer un dispositif de purge adaptable sur toutes les boîtes de transport de type FOUP standards.

Une plaquette est extraite ou introduite dans la boîte de transport environ toutes les 2 à 3 minutes. C'est donc une contrainte de temps pour réaliser l'opération de purge en temps masqué pendant le traitement d'un lot de substrats. L'invention a donc aussi pour but de proposer un procédé de purge permettant d'obtenir en moins de 3 minutes une purge efficace d'une boîte de transport FOUP lorsqu'elle est connectée à l'équipement.

L'objet de la présente invention est un dispositif de purge pour une boîte de transport ayant une ouverture d'entrée/sortie obturable par une porte de boîte et contenant des plaquettes de substrat superposées selon des plans parallèles, comprenant
- un volume, limité par une paroi, divisé en au moins une partie supérieure munie d'un orifice d'entrée de gaz de purge et en une partie inférieure munie d'un orifice de sortie de gaz de purge, les deux parties étant séparées par une cloison étanche, et
- une paroi principale, destinée à coopérer avec l'ouverture d'entrée/sortie de la boîte de transport, sensiblement perpendiculaire aux plans des plaquettes et comportant une pluralité d'ouvertures dont le plan médian est dans un plan parallèle aux plans des plaquettes, les ouvertures mettant en communication le volume du dispositif de purge avec la boîte de transport.

Selon une forme d'exécution préférentielle, les ouvertures sont dimensionnées par rapport à l'orifice d'entrée de gaz de purge de telle sorte que la partie supérieure du dispositif de purge se trouve en surpression. On comprend que la surface totale des ouvertures de communication entre la partie supérieure du dispositif de purge et la boîte de transport doit être suffisamment petite.

De référence le nombre d'ouvertures est au moins égal au nombre de plaquettes contenues dans la boîte de transport de manière à diriger le gaz de purge respectivement vers chaque plaquette. Le plus souvent les boîtes de transport peuvent contenir de 1 à 25 plaquettes.

Selon un premier mode de réalisation de l'invention, les ouvertures sont des fentes rectangulaires. Avantageusement les ouvertures ont une longueur du même ordre de grandeur que le diamètre des plaquettes de substrat. De préférence les fentes rectangulaires ont une hauteur inférieure à la distance séparant deux plaquettes successives, soit environ 10 mm, et de préférence encore les fentes ont une hauteur inférieure à 3 mm.

Selon un deuxième mode de réalisation, les ouvertures sont constituées par des trous alignés. Avantageusement les trous sont alignés sur une distance du même ordre de grandeur que le diamètre des plaquettes de substrat. De préférence les trous sont circulaires et ont un diamètre inférieur à la distance séparant deux plaquettes successives, et dé préférence encore les trous ont un diamètre inférieur à 2 mm.

Selon une variante, le dispositif de purge comporte en outre une pluralité de guides intercalés entre les ouvertures. Le nombre de guides est de préférence au moins égal au nombre de plaquettes contenues dans la boîte de transport. Ces guides permettent de diriger le flux gazeux au plus près des plaquettes.

Selon une forme d'exécution, les guides ont une longueur du même ordre de grandeur que le diamètre des plaquettes de substrat.

Selon une autre forme d'exécution de l'invention, les guides sont disposées dans les plans des plaquettes. Ainsi chaque guider se présente dans le même plan que la plaquette à laquelle il correspond. Avantageusement, l'extrémité de chaque guide présente une concavité qui vient épouser la forme de la plaquette circulaire correspondante.

De préférence, le dispositif de purge comprend aussi des moyens de connexion étanche à l'ouverture d'entrée/sortie de la boîte de transport.

L'invention a encore pour objet un système de purge au moyen du dispositif de purge précédemment décrit, d'une boîte de transport ayant une ouverture d'entrée/sortie obturable par une porte de boîte et contenant un empilement de plaquettes de substrat. Selon l'invention, le système de purge comporte une enceinte, ayant au moins un orifice de connexion à une boîte de transport muni d'une porte d'enceinte, et comprend des moyens d'actionnement de porte de boîte pour ouvrir et fermer la porte de la boîte de transport et des moyens d'actionnement du dispositif de purge pour connecter le dispositif de purge à la boîte de transport.

L'idée est d'apposer un dispositif de purge formant porte à la place de la porte de la boîte de transport, et d'utiliser ce dispositif de purge pour injecter un gaz propre dans la boîte de transport.

Le système de purge comporte en outre des moyens d'étanchéité au niveau de la zone d'accouplement de l'orifice de connexion à l'ouverture d'entrée/sortie de la boîte de transport.

L'invention a encore pour objet un procédé de purge au moyen du dispositif de purge précédemment décrit, d'une boîte de transport ayant une ouverture d'entrée/sortie obturable par une porte de boîte et contenant des plaquettes de substrat superposées selon des plans parallèles. Selon l'invention le procédé comprend les étapes suivantes :
- on connecte le dispositif de purge à l'ouverture d'entrée/sortie de la boite de transport,
- on injecte un gaz propre dans la partie supérieure du volume du dispositif de purge par l'orifice d'entrée de gaz de purge,
- on introduit le gaz dans la boîte de transport par des ouvertures dont le plan médian est dans un plan parallèle aux plans des plaquettes et qui communiquent avec la partie supérieure du volume du dispositif de purge,
- on recueille le gaz par des ouvertures dont le plan médian est dans un plan parallèle aux plans des plaquettes et qui communiquent avec la partie inférieure du volume du dispositif de purge,
- on évacue le gaz par l'orifice de sortie de gaz de purge dans la partie inférieure du volume du dispositif de purge.

Avantageusement, le gaz de purge est injecté dans la partie supérieure du dispositif de purge à une pression supérieure à 2 bars.

Le procédé de purge avec le dispositif de purge selon l'invention agit par convection forcée entre les plaquettes de substrat. Il permet de gagner en efficacité par rapport aux dispositifs de purge existants agissant par diffusion. L'opération de purge est plus rapide : 1mn au lieu de plusieurs minutes, Après 1 minute de circulation du gaz de purge à 50 slm, il reste en moyenne moins de 3,4% de dioxygène dans la boîte de transport.

Ce dispositif de purge et ce procédé de purge sont utilisable avec toutes les boîtes de transport de type FOUP actuellement en service.

A flux équivalent, le gaz neutre entre dans la boîte de transport avec une vitesse beaucoup plus faible que dans le cas où la purge est réalisée au moyen d'orifices de purge ménagés dans la paroi de fond des boîtes de transport standards. De ce fait, il y a moins de particules décollées et soufflées à l'intérieur de la boîte de transport. En outre il n'y a pas de rétrodiffusion possible de ces particules, ainsi les plaquettes sont protégées de tout risque de redéposition.

L'opération de purge peut être utilisée soit à la fin du traitement avant de refermer et déconnecter la boîte de transport, soit en temps masqué pendant le traitement entre deux opérations de transfert de plaquette. Le temps nécessaire pour attendre un rendement de purge de plus de 90% est inférieur à 2 minutes avec un flux de gaz de purge de 30 slm. Ce temps est plus court que la durée s'écoulant entre deux transferts de plaquettes.

D'autres caractéristiques et avantages de la présente invention apparaîtront à la lecture de la description qui suit d'un mode de réalisation, donné bien entendu à titre illustratif et non limitatif, et dans le dessin annexé sur lequel
- la figure 1 représenté schématiquement une installation de traitement de substrats à laquelle est connectée une boîte de transport,
- les figure 2a, 2b et 2c montrent schématiquement la manière dont une boîte de transport FOUP se connecte à un système de purge selon un mode de réalisation de l'invention,
- les figures 3a et 3b représentent des vues en perspective, respectivement des deux faces, d'un dispositif de purge selon un mode de réalisation de l'invention,
- la figure 4 représente une vue en perspective de l'une des faces d'un dispositif de purge selon un autre mode de réalisation de l'invention,
- la figure 5 montre le trajet du gaz de purge entre les différents plans dans une boîte de transport accouplée au dispositif de purge des figures 3a et 3b.

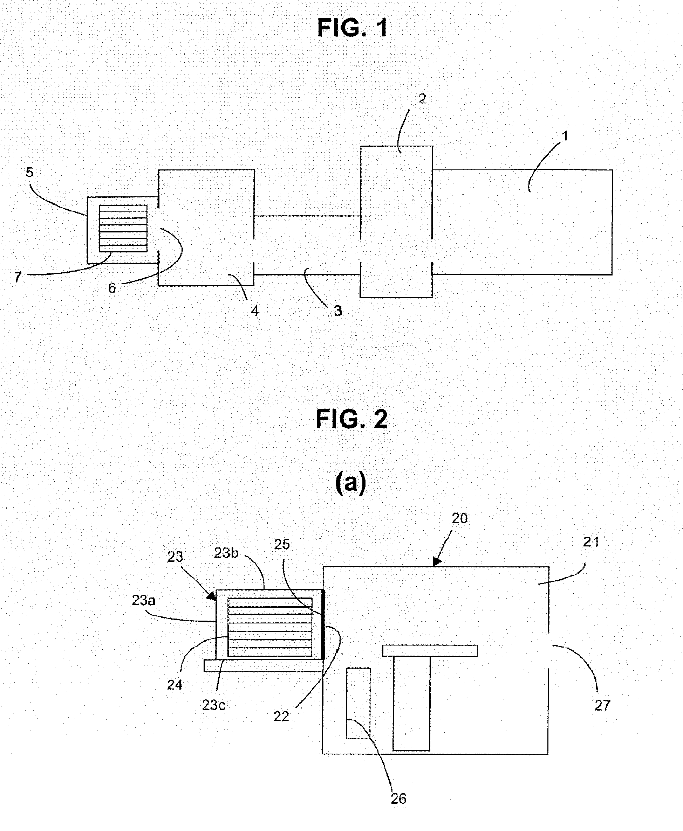

Une installation de traitement de substrat est représentée sur la figure 1. Elle comprend une chambre de procédé **1,** maintenue sous vide dans laquelle s'effectuent les opérations de fabrication ou de traitement des substrats tels que des plaquettes semiconductrices. La chambre de procédé **1** communique avec une chambre de transfert **2** également sous vide dans laquelle est placée la plaquette immédiatement avant et après son , traitement dans la chambre de procédé **1.** La chambre de transfert **2** communique avec un sas de chargement déchargement **3** dans lequel alternent les phases de mise sous vide et de remise à pression atmosphérique. Ce sas **3** met en relation la chambre de transfert **2** avec un module EFEM **4** qui permet le transfert de substrats à pression atmosphérique. Une ou plusieurs boites de transport **5** amovibles, de type FOUP par exemple, peuvent être connectées par un orifice **6** au module EFEM **4.** Ces boîtes **5** sont utilisées pour le stockage ou le transport des substrats à pression atmosphérique, notamment entre deux phases de fabrication ou entre deux équipements de traitement: Les plaquettes de substrat superposées dans un panier **7** peuvent ainsi être transférées une à une dans la chambre de transfert **2** par l'intermédiaire du module EFEM **4** et du sas **3.**

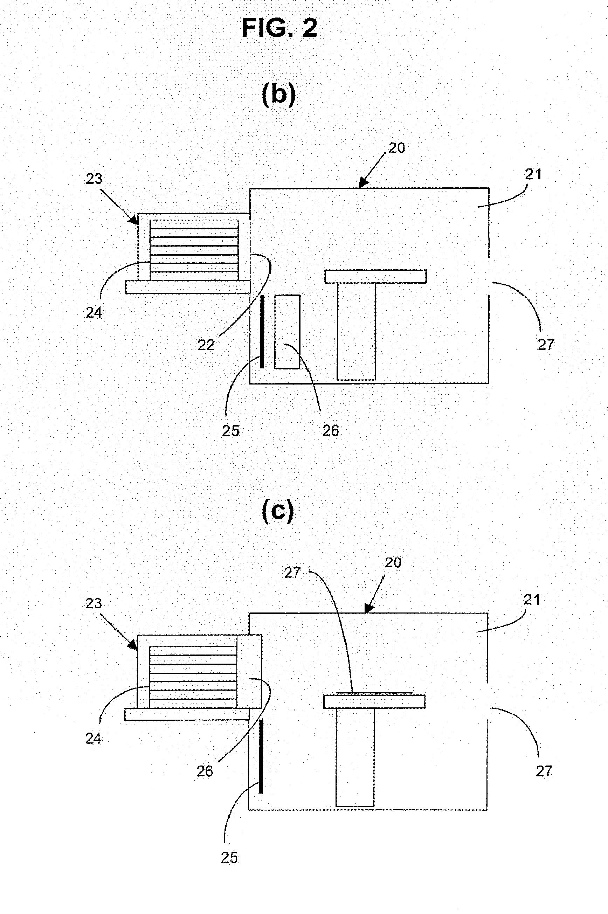

Les figures 2a, 2b et 2c correspondent aux étapes successives de l'accouplement d'une boîte de transport de type FOUP au dispositif de purge selon l'invention.

à figure 2a montre un système de purge **20** selon un mode de réalisation de l'invention comportant une enceinte **21** munie de parois étanches comportant au moins un orifice **22** pour permettre l'accouplement d'une boîte de transport **23**. Un panier **24** contenant des plaquettes de substrat disposées horizontalement est placé dans la boîte de transport **23.** La boîte de transport **23** comporte des parois latérales **23a,** une paroi de dessus **23b** et une paroi de fond **23c** sur laquelle repose le panier **24.** Dans une des parois latérales **23a** est ménagée une ouverture d'entrée/sortie obturée par une porte **25.** La porte **25** vient se placer face à l'orifice **22** du système de purge **20.** Un dispositif de purge **26** selon un mode de réalisation de l'invention est disposé dans la partie basse de l'enceinte **21.** Dans le cas où le système de purge **20** remplit la fonction d'un module EFEM, il comporte en outre un deuxième orifice **27** susceptible de se connecter à au sas de changement / déchargement d'une installation de traitement de substrat.

Une fois la boîte de transport **23** placé face à l'orifice **22** du système de purge **20,** sa porte **25** est déverrouillée grâce à des moyens d'actionnement de porte de boîte, puis déportée, vers la partie basse de l'enceinte **21** par exemple, afin de ne pas gêner le déplacement des piquettes vers le sas de chargement déchargement, comme le montre la figure 2b.

Le dispositif de purge **26** est positionné par des moyens d'actionnement robotisé à la place de la porte **25** de la boîte de transport **23** afin de procéder à la purge de la boîte de transport **23** et des plaquettes de substrat qu'elle contient, comme montré sur la figure 2c. Le dispositif de purge **26** s'applique sur la boîte **23** pour la fermer de façon étanche. Cette opération de mise en place du dispositif de purge **26** peut être réalisée à la fin du traitement de la totalité du lot de substrats et/ou entre chaque déplacement de plaquettes vers la chambre de procédé.

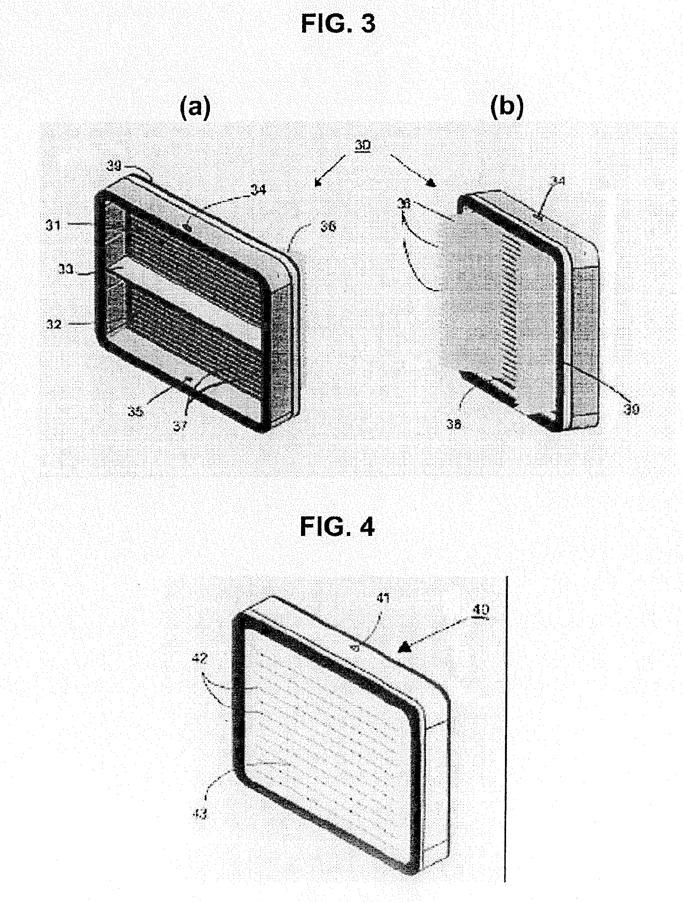

Un mode de réalisation particulier du dispositif de purge selon l'invention est représenté sur les figures 3a et 3b. Le dispositif de purge **30** comporte un volume limité par une paroi étanche divisé en une partie supérieure **31** et une partie intérieur **32** par une cloison séparatrice **33** étanche. La partie supérieure **31** comprend un orifice d'entrée **34** pour le gaz de purge. La partie inférieure **32** comprend un orifice de sortie **35** pour l'évacuation du gaz. Le volume du dispositif de purge est fermé du côté de l'enceinte du système de purge par une paroi étanche (non représentée) et ouvert vers l'intérieur de la boîte de transport. Le dispositif de purge **30** comporte des guides **36** horizontaux qui délimitent des ouvertures **37** dont le nombre est égal à celui des plaquettes contenues dans le panier. L'ouverture d'entrée/sortie de la boîte possède une dimension un peu supérieure au diamètre des plaquettes de substrat afin d'en permettre le passage. Le dispositif de purge **30** qui vient l'obturer en remplacement de la porte de boîte aura donc une dimension similaire, et les guides **36** et les ouvertures **37** auront de ce fait une longueur du même ordre de grandeur que celle des plaquettes. Dans le cas présent, les ouvertures **37** sont des fentes rectangulaires ayant une longueur de l'ordre de 300 mm et une hauteur inférieure à 3 mm, L'extrémité de chaque guide **36** présente une concavité **38** qui vient épouser la forme de la plaquette circulaire disposée horizontalement dans le panier, afin d'amener le gaz de purge au plus près de chaque plaquette pour en lécher la surface. Un joint **39** assure l'étanchéité de la communication entre la boîte de transport et le dispositif de purge **30.**

La figure **4** montre en perspective un autre mode de réalisation d'un dispositif de purge **40** comportant un orifice d'entrée de gaz **41.** Ici les ouvertures **42** sont constituées de rangées parallèles de trous **43,** chaque rangée horizontale correspondant au plan horizontal d'une plaquette. Le dispositif de purge **40** ne comporte pas de guides.

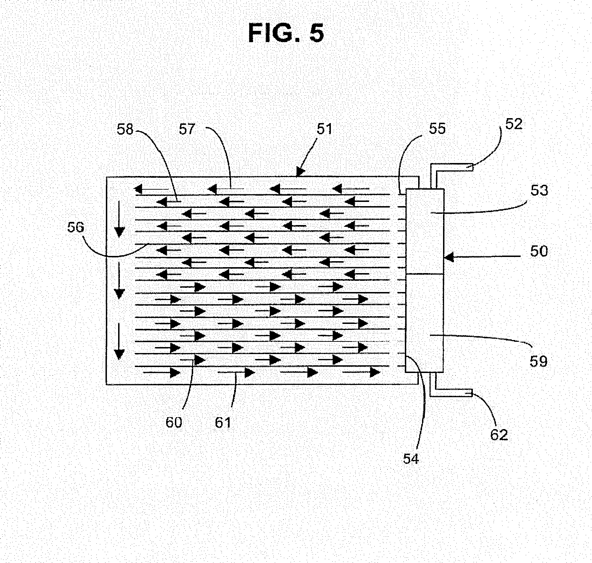

Le procédé de purge à maintenant être décrit en référence à la figure 5. Un dispositif de purge 50 selon un mode de réalisation de l'invention est connecté de manière étanche à l'ouverture d'entrée/sortie d'une boîte de transport **51** de manière à mettre en communication le volume du dispositif de purge **50** avec l'intérieur de la boîte de transport **51.** Un gaz de purge propre, de préférence un gaz neutre, est injecté par l'orifice d'entrée de gaz **52** dans la partie supérieure **53** du volume du dispositif de purge **50,** avantageusement à une pression supérieure à 2 bars. Le gaz de purge est alors dirigé à travers les ouvertures **54** par les guides **55** autour et vers l'intérieur du panier **56**. Le flux de gaz de purge se déplace parallèlement aux plans des plaquettes **57,** aux plans des guides **55** et aux plans médians des ouvertures **54,** comme le montrent respectivement les flèches **58** et **59.**

Après avoir balayé les plaquettes situées dans le haut du panier **56,** le gaz de purge retourné vers la partie inférieure **60** du volume du dispositif de purge **50**, en balayant les plaquettes situées dans le bas du panier **56,** comme le montrent les flèches **61** et **62.** Le gaz de purge s'échappe enfin par l'orifice de sortie **63,**

Les ouvertures **54** sont dimensionnées par rapport à l'orifice d'entrée de gaz **52** de telle sorite que la partie supérieure **53** du dispositif de purge **50** soit en légère surpression, afin que le gaz neutre et propre entre due façon homogène dans la boîte de transport **51.** Les ouvertures **54** peuvent prendre la forme due fentes de faible hauteur ou d'une succession de trous alignés de faible diamètre, par exemple de diamètre inférieur à 2 mm. Une faible section de ces ouvertures **54** permet une entrée du gaz avec une répartition homogène sur toute la surface de la partie supérieure **53** du dispositif de purge **50.**

## Revendications

1. Dispositif de purge pour une boîte de transport, ayant une ouverture d'entrée/sortie obturable par une porte de boîte et contenant des plaquettes de substrat superposées selon des plans parallèles, comprenant
- un volume limité par une paroi étanche divisé en au moins une partie supérieure munie d'un orifice d'entrée de gaz de purge et en une partie inférieure munie d'un orifice de sortie de gaz de purge, les deux parties étant séparées par une cloison étanche, et
- une paroi principale, destinée à coopérer avec l'ouverture d'entrée/sortie de la boîte de transport, sensiblement perpendiculaire aux plans des plaquettes et comportant une pluralité d'ouvertures dont le plan médian est dans un plan parallèle aux plans des plaquettes, les ouvertures mettant en communication le volume du dispositif de purge avec la boîte de transport.

2. Dispositif de purge selon la revendication 1, dans lequel les ouvertures sont dimensionnées par rapport à l'orifice d'entrée de gaz de purge de telle sorte que la partie supérieure du dispositif de purge se trouve en surpression.

3. Dispositif de purge selon l'une des revendications 1 et 2, dans lequel le nombre d'ouvertures est au moins égal au nombre de plaquettes contenues dans la boîte de transport.

4. Dispositif de purge Selon zone des revendications 1 à 3, dans lequel les ouvertures sont des fentes rectangulaires de longueur du même ordre de grandeur que le diamètre des plaquettes de substrat.

5. Dispositif de purge selon l'une des revendications 1 à 3, dans lequel les ouvertures sont constituées par des trous alignés sur une distance sensiblement du même ordre de grandeur que le diamètre des plaquettes de substrat.

6. Dispositif de purge selon l'une des revendications précédentes, comportant en outre une pluralité de guides intercalés entre les ouvertures.

7. Dispositif de purge selon la revendication 6, dans lequel le nombre de guides est au moins égal au nombre de plaquettes contenues dans la boîte de transport et les guides sont disposées dans les plans des plaquettes.

8. Dispositif de purge selon la revendication 7, dans lequel chaque guide est disposé dans le même plan que la plaquette à laquelle il correspond, et l'extrémité de chaque guide présente une concavité qui vient épouser la forme de la plaquette circulaire correspondante.

9. Dispositif de purge selon l'une des revendications précédentes, comportant en outre des moyens de connexion étanche à ouverture d'entrée/sortie de !a boîte de transport.

10. Système de purge d'une boîte de transport, ayant une ouverture d'entrée/sortie obturable par une porte de boîte et contenant un empilement de plaquettes de substrat, au moyen du dispositif de purge selon l'une des revendications précédentes, comportant une enceinte ayant au moins un orifice de connexion à une boîte de transport muni d'une porte d'enceinte, et comprenant des moyens d'actionnement de porte de boîte pour ouvrir et fermer la porte de la boîte de transport et des moyens d'actionnement du dispositif de purge pour connecter le dispositif de purge à la boîte de transport.

11. Procédé de purge d'une boîte de transport, ayant une ouverture d'entrée/sortie obturable par une porte de boîte et contenant des plaquettes de substrat superposées selon des plans parallèles, au moyen du dispositif de purge selon l'une des revendications 1 à 9, comprenant les étapes suivantes:
- on connecte le dispositif de purge à l'ouverture d'entrée/sortie de la boîte de transport,
- on injecte un gaz de purge dans la partie supérieure du volume du dispositif de purge par l'orifice d'entrée de gaz de purge,
- on introduit le gaz dans la boîte de transport par des ouvertures dont le plan médian est dans un plan parallèle aux plans des plaquettes et qui communiquent avec la partie supérieure du volume du dispositif de purge,
- on recueille le gaz par des ouvertures dont le plan médian est dans une plan parallèle aux plans des plaquettes et qui communiquent avec la partie inférieure du volume du dispositif de purge,
- on évacue le gaz par l'orifice de sortie de gaz de purge dans la partie inférieure du volume du dispositif de purge.

12. Procédé de purge selon la revendication 11, dans lequel le gaz de purge est injecté dans la partie supérieure du dispositif de purge à une pression supérieure à 2 bars.
